# EUROPEAN PATENT APPLICATION

(11) **EP 2 600 140 A1**
(43) Date of publication of application: **05.06.2013**
(21) Application number: 11191122.8
(22) Date of filing: 29.11.2011
(51) Int. Cl.: G01N 21/95

(54) **Inspection system**

(71) Applicant: Hennecke Systems GmbH, 53909 Zülpich (DE)
(72) Inventor: Esser, Thomas, 52391 Vettweiß (DE); Jansen, Stephan, 53940 Hellenthal (DE); Peters, Rainer, 53909 Zülpich (DE)
(74) Representative: Patentbüro Paul Rosenich AG

(57) **Abstract**

The invention relates to an inspection system (1) for inspecting flat photosensitive semiconductor objects, such as wafers, solar cells or intermediate stages thereof, said inspection system (1) comprising:
transport means (3) for transporting the flat objects (2) within a transport path (6) in a transport direction (7);
imaging means (8) for imaging the leading edges (2a) and/or trailing edges (2b) of the flat objects (2) within the transport path (6) from at least one observation optical path (9, 19);
a mirror arrangement (10) having at least one mirror surface (11) deflecting the observation optical path (9);
wherein the mirror arrangement (10) is arranged above or beneath the transport path (6) and extends transversely to the transport direction (7),
and wherein the observation optical path section (9a) that extends from the transport path (6) to the mirror surface (11) encloses an observation angle (α) with the transport direction (7).

## Description

The invention relates to an inspection system and method for inspecting flat photosensitive semiconductor objects, such as wafers, solar cells or intermediate stages thereof. Particularly the invention relates to the inspection of the leading and trailing edges of flat photosensitive semiconductor devices, especially silicon wafers and solar cells on the fly without handling.

Quality control devices for wafers in the photovoltaic industries are known in prior art (e.g. from Hennecke Systems GmbH)

Such inspection modules are adapted for measuring mono and multi crystalline wafers from 125mm x 125mm up to 210mm x 210mm or larger.

The following parameters can be measured with the Hennecke Systems Wafer Inspection Module:
- Thickness, TTV (Total Thickness Variation = difference of the maximum thickness value and the minimum thickness value of silicium wafers)
- Saw marks (saw marks = grooves on the wafer surfaces, which are generated during the sawing process by a wire saw)
- Edge defects (edge defects = material breakouts at the wafer edges)
- Chippings (chipping = wafer surface spall)
- Resistivity (resistivity = specific electrical resistance of a wafer)
- Stain (stain = visible dirt area on the wafer surface)
- Micro Crack / Inclusions (inclusions = carbon inclusions, generated during the growing process of silicon ingots)
- Geometry (geometry = dimensions in length and width of a wafer, rectangularity, parallelism)
- Sori, Bow (sori = waviness of the wafer surface, bow = difference of the highest point of one wafer surface to the lowest one of the same wafer surface)
- Lifetime (lifetime = lifetime of the minority carriers inside the wafer. The result is an indication of the degree of the wafer's contamination)
- Grain size (grain size = sizes of the different silicon grains a multi crystalline silicon wafer consists of)

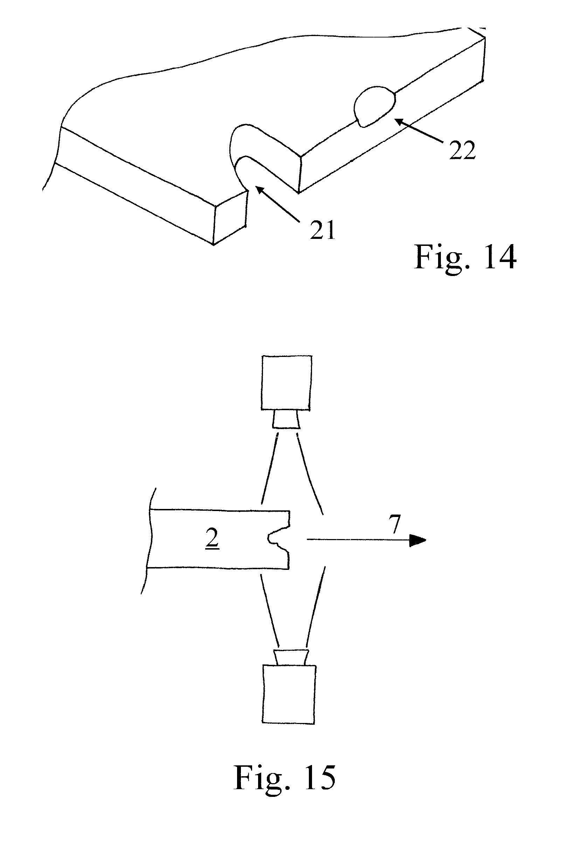

With the standard Hennecke edge defect detection system it is possible to detect v-type breakages and chippings on all four wafer edges. It is an optical measurement system. To detect defects on the wafer edges there are installed two line scan cams with a resolution of 7500 pixels and a maximum trigger frequency of 4kHz. Thus the maximum resolution for the edge inspection is 28µm/pixel for the edges which are aligned crosswise to the running direction and 55µm/pixel for the edges that are aligned in running direction. Two line scan illuminators are mounted with an angle of 45° to the wafer surface. Each line scan camera is positioned perpendicular to one of the two wafer surfaces (see figure 15). The optical axis of each line scan camera is positioned perpendicular to one of the two wafer surfaces. The wafers are continuously transported by a conveyor belt in a plane transport path in a transport direction.

Due to the fact that in the standard edge defect system the cams are aligned perpendicular to the wafer surfaces, some edge defects that don't extend to the top or the bottom wafer surface can't be detected as shown in figure 15.

A further drawback is the different chip detection sensitivity according to the location of the chippings. Due to the angle of illumination of 45° partly directed in transport direction the leading edge and the trailing edge of the wafers are differently illuminated. That means more precisely, the chance to detect chips on the trailing edge is higher than to detect chippings on the leading edge due the flat angle of 45° of the line scan illuminators.

### Edge inspection system of the company Yasunaga

With Yasunaga's edge inspection system it is possible to examine the lateral wafer edges from the top and bottom surface as well as from the edge site. At the lateral sides of the transport path there are installed mirrors to diffract the light in that way, that it is possible to grab images from the top, bottom and edge side with only one line scan cam. This constitutes a first inspection unit. However, it is not possible to inspect at the same time the leading and/or trailing edge of the wafer. In order to also inspect the leading and trailing edge of the wafer, the wafer has to be rotated by 90° and a second inspection unit has to be provided downstream of the first inspection unit and the rotation procedure.

The drawback of that edge inspection system is the extra wafer stressing rotating procedure. The 90° rotation is necessary to inspect all four wafer edges with the Yasunaga edge inspection system. Moreover, the rotating station requires much space.

The object of the invention is to overcome these problems of the prior art systems and to provide an inspection system for inspecting the leading and/or trailing edges of flat objects without changing their orientation on the transport means. Furthermore, the inspection procedure shall be sensitive and reliable to any kind of defects, particularly, better at detecting shallow chipping than systems known from prior art. The inspection system shall be a cost effective alternative to the described systems and require less space.

This object is achieved by said inspection system comprising:
transport means for transporting the flat objects within a transport path in a transport direction;
imaging means for imaging the leading edges and/or trailing edges of the flat objects within the transport path from at least one observation optical path;
a mirror arrangement having at least one mirror surface deflecting the observation optical path;
wherein the mirror arrangement is arranged above or beneath the transport path and extends transversely to the transport direction,
and wherein the optical axis of the observation optical path section that extends from the transport path to the mirror surface encloses an observation angle α with the transport direction, wherein preferably the observation angle α is less than 45 degrees.

The mirror arrangement extending transversely to the transport direction allows the imaging means to see the leading and/or trailing edge at another observation angle as it would be if the optical axis of the imaging means is straightforward directed towards the leading/trailing edge. This allows arranging the mirror arrangement in direct vicinity of the transport path, while the imaging means, preferably a camera, e.g. a CCD camera, may be located at a distance to the transport path, without relinquishing the option of an optimal observation angle. The mirror surface is arranged at least partially in the field of view of the imaging means. The mirror surface is inclined with respect to the plane of the transport path. This means precisely, the mirror surface is tilted around an axis, which is perpendicular to the transport direction.

Due to the fact, that the imaging means can be spaced from the transport path, it is not prone to dirt and dust arising in the vicinity of the transport means. Preferably, the observation angle is less than 45°, in order to see as much as possible the leading/trailing edges from their front. The mirror surface and the imaging means may be arranged with respect to one another such, that the observation angle becomes very small.

The observation optical path is the optical path extending from the leading or trailing edge of the flat object in the imaging position to the imaging means or vice versa. According to the invention, the observation optical path runs between the object and the imaging means over a mirror.

With camera in the end the relevant or used pixels of the camera is meant.

The optical axis of the observation optical path section that extends from the transport path to the mirror surface corresponds to the central axis that meets the center line of the surface of the leading or trailing edge in the imaging position.

At the same time the mirror arrangement does not require much space, since it is arranged in direct vicinity to the transport path. The mirror arrangement, furthermore, does not disturb the flat objects during their transport, since it is arranged above or beneath the transport path.

An imaging position is defined along the transport path for imaging the leading edge and/or an imaging position is defined along the transport path for imaging the trailing edge. The leading and/or trailing edge is at this respective imaging position, when the imaging means takes a picture. It is not necessary that the leading/trailing edge stops at the imaging position. A continuous transport along the transport path without stop at the imaging positions is preferred.

Preferably, the transport path is a plane transport path being parallel to the flat objects. The angle of observation is defined as the angle of the observation optical path section, extending between the plane of transportation in a certain position (the edge's imaging position) and the mirror, and the transport direction and is used to image the wafer in that position.

The transport means or conveying system may be a conveyer belt, preferably consisting of at least two parallel wires. Wafer stand for semiconductor wafers, solar cells and all intermediate stages.

With the invention all four edges of mono and multi crystalline wafers which normally come in 156mm x 156mm shall be inspected with cameras, without the necessity of stopping or rotating the wafers. The lateral edges may be inspected as known from prior art, the leading/trailing edges are inspected by the inventive solution.

Preferably the observation angle α is less than or equal to 15 degrees, even more preferred less than or equal to 10 degrees. The observation angle α is preferably as small as possible. This angle is defined in the plane perpendicular to plane of the transport path or the plane of the inspected object. This allows to make most reliable images of the leading/trailing edges. The observation optical path section which extends between the leading/trailing edge of the object in the transport path and the mirror meets the edge surface of the object at an angle (90 - α), thus between 75 and 90 degrees, preferably between 80 and 90 degrees, in the case that there is a perfectly plane edge surface, which is perpendicular to the transport direction.) Such a steep angle allows detection of all kinds of defects. There are no geometrical barriers which hides some kinds of defects as this is the case in prior art systems. With other words: The mirror surface is used to bring/deflect the observation optical path of the camera into the right direction/observation angle (about vertical/in about the plane of the object/wafer).

Preferably the mirror arrangement has two mirror surfaces being inclined to each other and defining two observation optical paths, one of them being adapted for inspecting the leading edges of the flat objects and one of them being adapted for inspecting the trailing edges of the flat objects. This allows detection of both edges within one space-saving unit.

Preferably both mirror surfaces are arranged in the field of view of the same imaging means and both observation optical paths are seen by the imaging means. The advantage of this embodiment consists in the fact, that only one camera is required for imaging both, the leading edge and the trailing edge. This results in a cost-effective and space-saving arrangement.

Preferably the angle γ of inclination between the two mirror surfaces amounts between 80 and 110 degrees, preferably between 90 and 100 degrees. This allows a space-saving arrangement with the mirror surfaces being connected by means of a common edge. At the same time this facilitates the use of only one camera for the imaging of both edges.

Preferably the transport means has a gap, in which the mirror arrangement is located beneath the transport path. The mirror arrangement in the gap may be mechanically protected and not exposed to other moving parts of the inspection system. This avoids crashes with the delicate mirror surface.

The mirror arrangement in the gap may also comprise two mirror surfaces wherein the field of view (FOV) of the camera is split as described above.

Preferably the transport means is a conveyor belt, preferably made of at least two parallel narrow belts.

Preferably, the inspection system has at least one illumination means for illuminating the leading edge and/or the trailing edge of the flat object and wherein the angle between the illumination path of the illumination means and the observation optical path section that extends from the transport path to the mirror surface is smaller than 20 degrees, preferably smaller than 10 degrees.

Preferably the gap is made by a local deflection of the belt(s). This is a preferred embodiment, since the continuous speed of the objects may be maintained during their complete transport trough the inspection system.

Alternatively the gap is provided between two separate sections of the transport means. The transport means may comprise two consecutive conveyer belts for forming the gap in between them.

Preferably a sensor means, preferably a light barrier, is arranged at a detection position of the transport path for detecting an object, and wherein the sensor means is connected with the imaging means. The sensor allows to trigger the imaging means and - if additionally provided - illumination means.

Preferably the optical axis of the observation optical path section extending between the mirror surface and the imaging means, has an angle with the plane transport path between 80 to 100 degrees, preferably between 85 and 95 degrees, most preferably approximately 90 degrees. This allows to arrange the imaging means at a distance from the transport means and space it from dirt and dust. At the same time this allows a compact and space-saving arrangement.

Preferably the inspection system includes an alignment tool for aligning the objects parallel to the transport direction, wherein preferably the alignment tool is comprised of converging guides being arranged on the lateral sides of the transport path. This allows the imaging of reliable images, since all points of the leading/trailing edge are in the focus line of the system: imaging means and mirror.

The object is also achieved with an inspection method for inspecting flat objects, such as wafers, solar cells or intermediate stages thereof, said inspection method comprises the steps of:
transporting the flat objects within a plane transport path in a transport direction;
imaging the leading edges and/or trailing edges of the flat objects within the transport path from at least one observation optical path;
wherein the observation optical path is deflected by a mirror surface of a mirror arrangement;
wherein the mirror arrangement is arranged above or beneath the transport path and extends transversely to the transport direction,
and wherein the optical axis of the observation optical path section that extends from the transport path to the mirror surface encloses an observation angle α with the transport direction.

Preferably the observation angle α is less than or equal to 15 degrees, preferably less than or equal to 10 degrees.

Preferably the inspection method is performed with an inspection system according to the embodiments as described above.

The advantages of the invention may be summarized as follows: No additional wafer stressing (rotating and accelerating and decelerating); No further process costs due to additional wafer handling systems; Only one measurement design to inspect the leading edge as well as the trailing edge; Only one camera needed (provided it has enough pixels) for inspecting trailing and leading edge; The mirror is facing to the imaging means (e.g. upward) and gets dirty, not the camera lens that is much harder to clean. Also the observation path may extend perpendicular to the transport direction, reducing space need in the transport direction. The observation path can be kept long so that the objective used for the camera can have a relatively small angle, reducing cost. Also imaging means are much larger than the mirror, thus allowing the mirror to be much closer to the wafer to be inspected than would be possible with a camera with a normal lens. The same holds for the illumination that now can be placed such that its direction almost coincides with the observation direction of the imaging means.

Again a camera would be larger than the mirror is, thus blocking light coming from a direction comparable to the observation path.

To stress the wafers as little as possible, the laminar objects are transported through the inspection system e.g. on a conveyor belt without additional handling (e.g. rotating) and with a continuous speed with a transportation speed of preferably at least 220mm/sec. The inspection of the object/wafer edges is done on the flight. For quality assurance requirements (detecting defects down to 50µm), the pixel resolution may be adjusted to least 25µm/pixel.

Due to the inventive solution the laminar objects do not clash with the cameras during the front side and back side edge detection. To avoid object/wafer stresses, also a further handling procedure e.g. the rotating procedure in the Yasunaga system is not necessary any more to reliably inspect the leading edge and the trailing edge.

Further embodiments of the invention are indicated in the figures and in the dependent claims. The list of reference marks forms part of the disclosure. The invention will now be explained in detail by the drawings. In the drawings:
Fig. 1 shows a first embodiment for inspecting the leading edge of a moving flat object,
Fig. 2 shows a second embodiment for inspecting the trailing edge of the moving flat object,
Fig. 3 shows a third embodiment for inspecting the leading edge and the trailing edge of a moving flat object,
Fig. 4 shows the embodiment of Fig. 3 from a top view,
Fig. 5 shows an imaging means comprising three cameras arranged transversally to the transport direction,
Fig. 6 shows a fourth embodiment with the mirror arrangement beneath the transport path and the imaging means above the transport path,
Fig. 7 shows schematically the snap shot of the leading edge,
Fig. 8 shows schematically the snap shot of the trailing edge,
Fig. 9 shows the deflected fields of view of the cameras overlapping the edge of the object,
Fig. 10 shows the geometrical distances in a schematic illustration
Fig. 11 shows an alignment tool for the objects,
Fig. 12 the inspection method for inspecting the lateral edges of the object in a front view,
Fig. 13 the inspection method for inspecting the lateral edges of the object in a top view,
Fig. 14 shows different types of damages,
Fig. 15 shows an inspection method according to prior art,
Fig. 16 shows a further embodiment of the inventive inspection system.

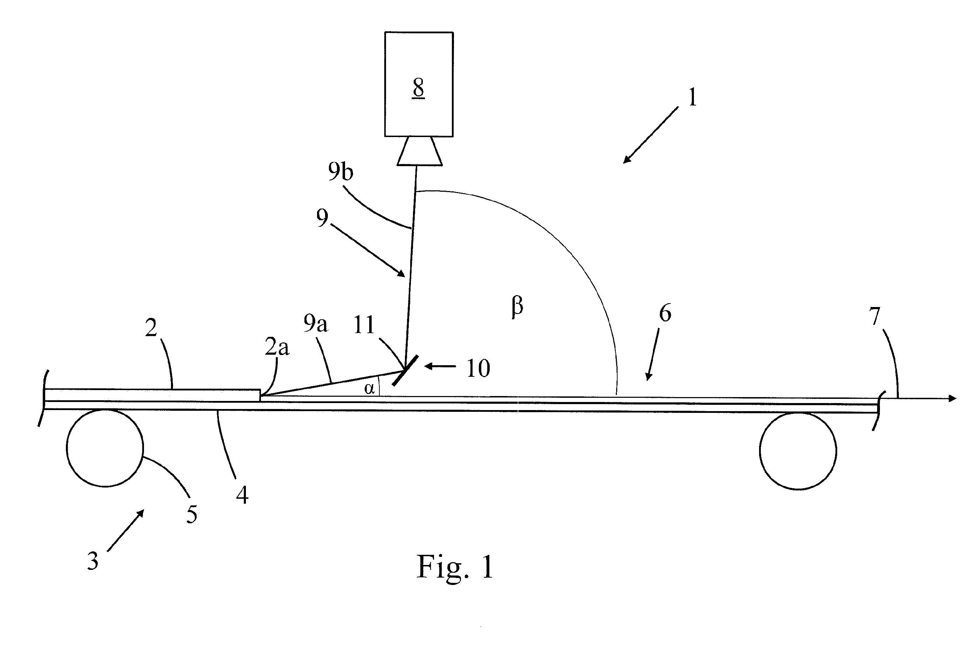

Fig. 1 shows a first embodiment of an inventive inspection system 1 for inspecting flat objects 2. The inspection system 1 comprises transport means 3 for transporting the flat objects 2 within a plane transport path 6 in a transport direction 7. In the present embodiment the transport means 3 is a conveyor belt 4 supported by rollers 5. The flat sides of the object 2 are oriented parallel to the transport plane.

A camera as imaging means 8 for imaging the leading edge 2a of the flat object 2 is arranged above the transport path 6. An observation optical path 9 extends from the camera towards the transport path 6. A mirror arrangement 10 having at least one mirror surface 11 deflects the observation optical path 9 from the object 2 to the camera and creates two path sections 9a and 9b.

The observation optical path section 9b extending between the mirror surface 11 and the imaging means 8, has an angle β with the plane of the transport path 6 between 80 and 100 degrees, preferably between 85 and 95 degrees, most preferably approximately 90 degrees. The optical axis of the path section 9b is the central beam path of that (partial) field of view path corresponding to the respective mirror surface.

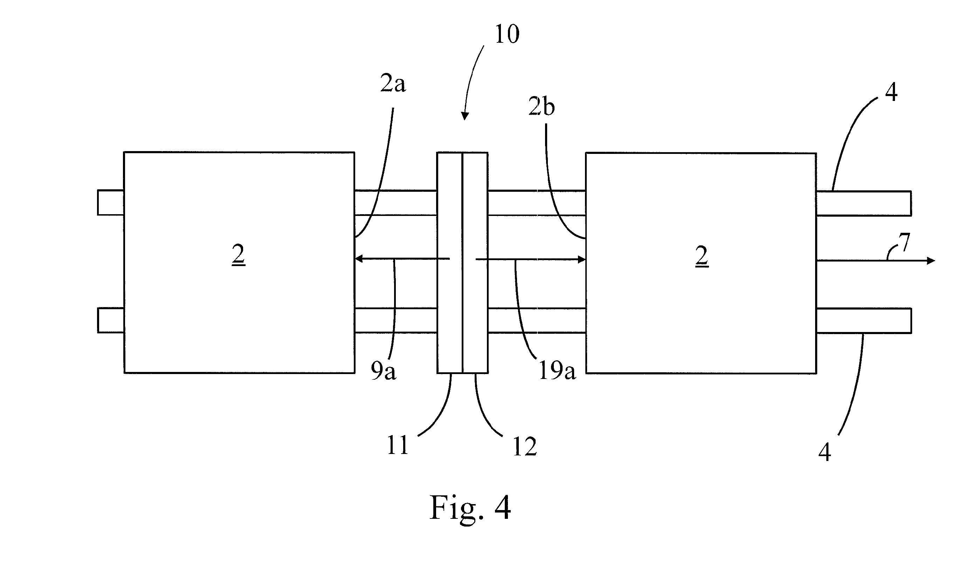

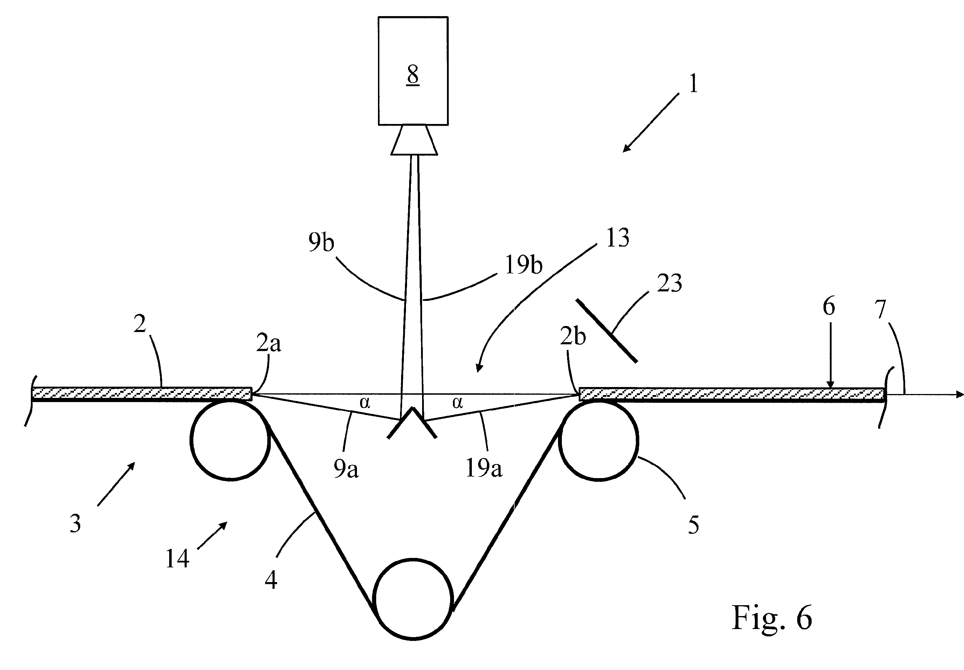

Preferably the observation angle α between the transport direction 7 and the path section 9a or its optical axis, respectively, that extends from the transport path 6 to the mirror surface 11 is less than or equal to 15 degrees, preferably less than or equal to 10 degrees. In order to not disturb the movement of the object 2 the mirror arrangement 10 is arranged above or beneath (Fig. 6) the transport path 6. As can be seen from Fig. 4 the mirror arrangement 10 extends transversely to the transport direction 7. The mirror surface 11 is inclined with respect to the transport plane 6.

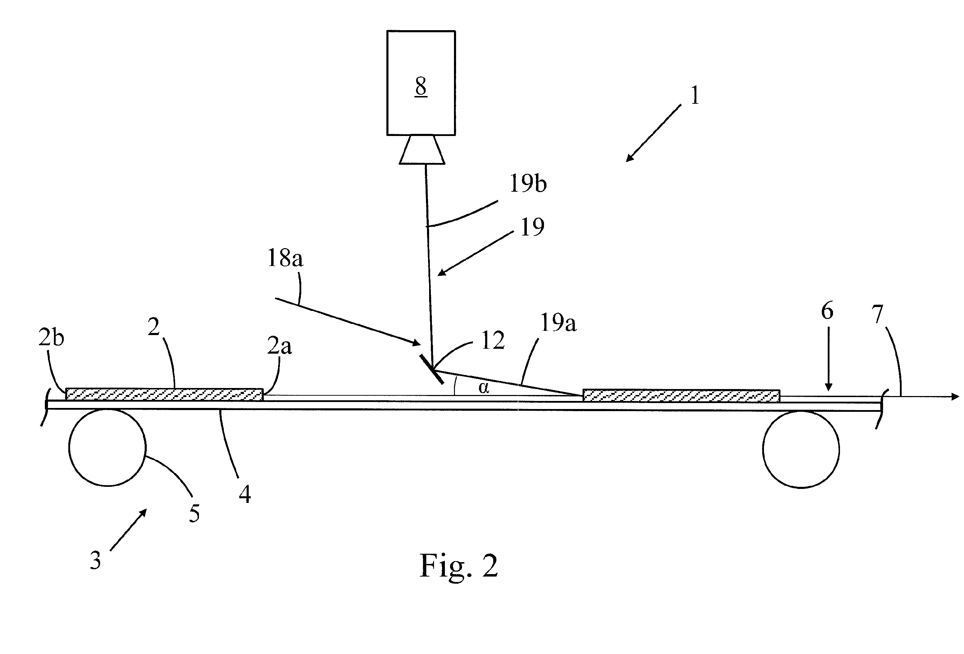

Fig. 2 shows a second embodiment of an inventive inspection system 1. The mirror surface 12 is tilted such, that the trailing edge 2b of the object can be imaged under an observation angle α.

The inspection system 1 of Fig. 2 has an illumination means 18a (indicated by an arrow) for illuminating the trailing edge 2b of the flat object 2. The angle between the illumination path from the illumination means 18a towards the object's edge 2b and the observation optical path section 19a that extends from the transport path 6 to the mirror surface 11 is smaller than 20 degrees, preferably smaller than 10 degrees. Preferably, a second illumination means 18b is provided to illuminate the leading edge (see e.g. Fig. 6).

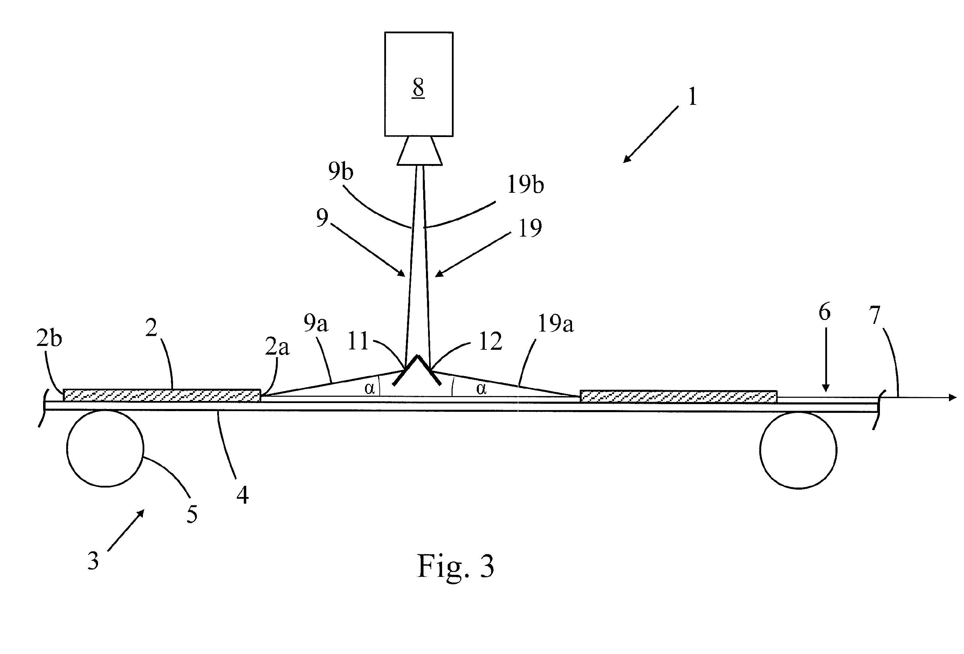

Fig. 3 shows a third embodiment of an inventive inspection system 1 being capable to inspect both, the leading edges 2a and the trailing edges 2b of an object 2. The mirror arrangement 10 has two mirror surfaces 11, 12 which are inclined to each other and define two observation optical paths 9, 19, one of them being adapted for inspecting the leading edges 2a and the other being adapted for inspecting the trailing edges 2b of the flat objects 2 under an observation angle α. Both mirror surfaces 11, 12 are arranged in the field of view of the same imaging means 8 and both observation optical paths 9, 19 are seen by the imaging means 8.

Preferably, the angle of inclination γ between the two mirror surfaces 11, 12 amounts more than 90, preferably approximately 100 degrees. The angle α should be as small as possible. This means that, if the camera is used for imaging both the leading and the trailing edge under the same angle, the angle γ should be as large as possible if the mirror is above the conveyer belt. If the mirror is arranged below the conveyor belt (Fig. 6) the angle γ should be as small as possible.

Such inclinations γ allow to make images from both observation optical paths 9, 19 by the same camera. As the object 2 comes from the left the leading edge 2a comes into a first imaging position, which is that region in which the optical path section 9a crosses the transport path 6, and a first image is taken by the camera. The object 2 continuously moves in transport direction 7 and reaches a second imaging position, which is that region in which the optical path section 19a crosses the transport plane 6, and a second image is taken by the camera. In case of only one mirror, the angle between the transport direction and the mirror is preferably half of what is mentioned above. Note that all angles given here are for the case where the optical axis of the camera extends vertically. If the camera is tilted, other angles can be beneficial as well.

Fig. 4 shows the inspection system 1 in a view on the plane of the transport path 6. The mirror surfaces 11, 12 are connected at an edge facing towards the camera. The edge extends transversely to the transport direction 7. The transport means 3 is a conveyor belt made of at least two parallel narrow belts 4.

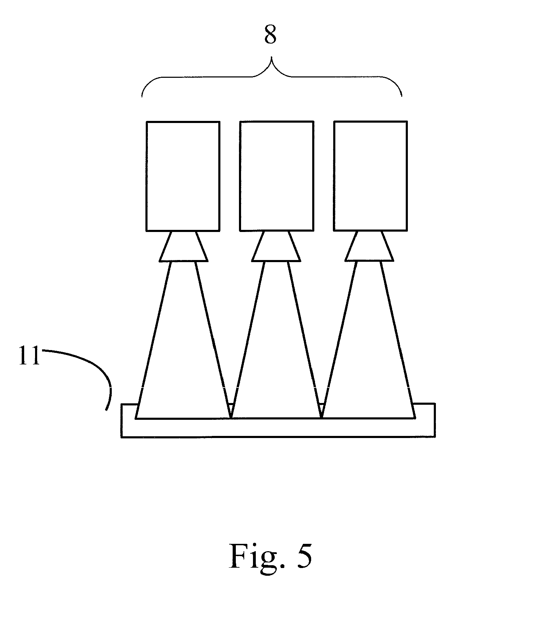

Fig. 5 shows an imaging means 8 comprising three cameras arranged transversally to the transport direction 7. The fields of view of all cameras shall cover the entire leading/trailing edge of the object and the three cameras together have enough pixels to achieve the desired resolution (pixels/µm).

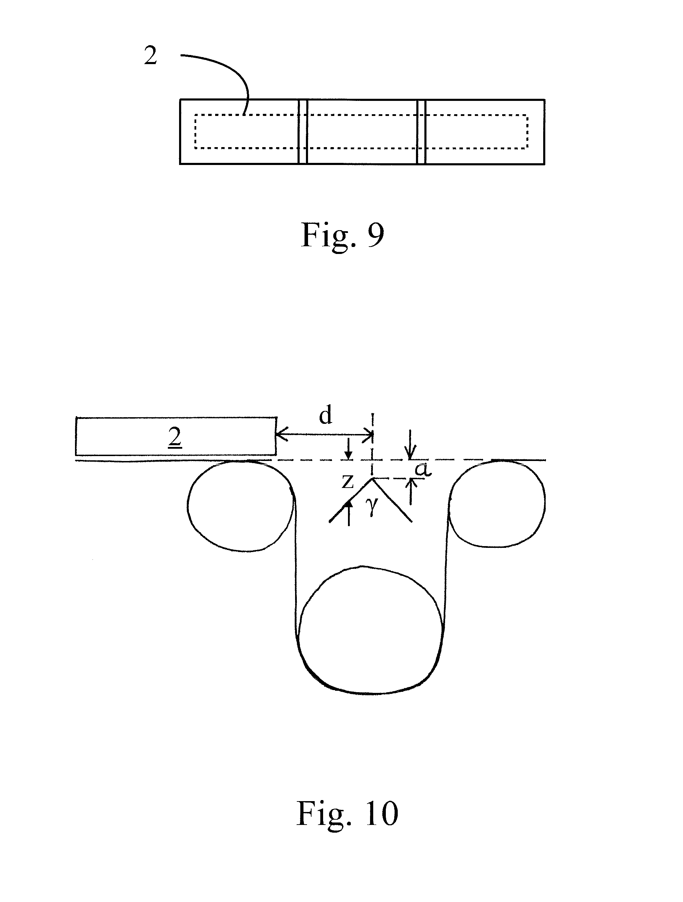

To capture the whole wafer length of at most 156mm in transport direction 7 and to capture both, the leading wafer edge as well as the trailing wafer edge in transverse direction to the transport direction 7 with the preferred pixel resolution of at least 25µm/pixel, it is preferred to use at least three cams in a matrix camera arrangement. The fields of view of these three matrix cams have to cover the whole edge length. The fields of view overlap each other for about 2mm (see Fig. 9) for robustness. Furthermore, the fields of view of the left and right inspection cam have to overlap the lateral edges for at least 4mm. That means the three matrix cams have to capture a field of view of 168mm in the horizontal direction.

Alternatively, a camera with higher resolution or a line scan camera such as a TDI line scan camera may be used, so that only one imaging device would be necessary to inspect the leading edge.

Fig. 6 shows a fourth embodiment of the inspection system 1. The transport means 3 has a gap 13, in which the mirror arrangement 10 is located beneath the transport path 6. The gap 13 is made by a local deflection 14 of the belt(s) 4 by means of a deflecting roller arrangement. Alternatively the gap 13 may be provided between two separate sections of the transport means 3.

One advantage of the embodiment in fig 6 is that the back ground can be defined by placing a background shield 23 behind the edge in the imaging position.

In the embodiment of fig 1, the transport means would extend between the back ground and the mirror, what may be a disadvantage.

The most relevant part of the invention is the arrangement of one or more mirror surfaces (which are aligned rectangular (see figure 4) to the transport direction of the conveyor belt) and which are placed above or beneath the conveyor belt 4 with the aim to diffract the observation optical path 9 of the imaging means 8 in that way, that a path section 9a meets the leading and/or the trailing edge of laminar, photosensitive semiconductor devices, especially silicon wafers and solar cells and all intermediate stages with a maximum deviation of 15, preferably 10 degrees to the perpendicular of the edge surface without the risk that the transported laminar, photosensitive semiconductor devices, especially silicon wafers clash with the mirror surfaces 11, 12. Preferably, the optical axis of the camera is mainly vertical (+/-5 degrees) and the optical axis of the observation optical path section 9a, 19a (extending between transport path and mirror surface) extends mainly horizontal (+/-10 degrees).

In the embodiment of Fig. 6 one camera is used to look at the trailing edge of a wafer and the leading edge of the next pone coming. That means the visible field of the cams is split into two parts: the first part is diffracted to the running direction to inspect the trailing edge and the second part is diffracted to the opposite running direction to inspect the leading edge. In this way, only the half the amount of cameras is needed. With that design it is possible to inspect the leading edge as well as the trailing edge of the wafers on the fly without rotating the wafers and thus without stressing them.

One image may be taken optimized to see a leading and a second image may be taken that is optimized for a trailing edge. Also one image may be taken showing both a trailing and a leading edge.

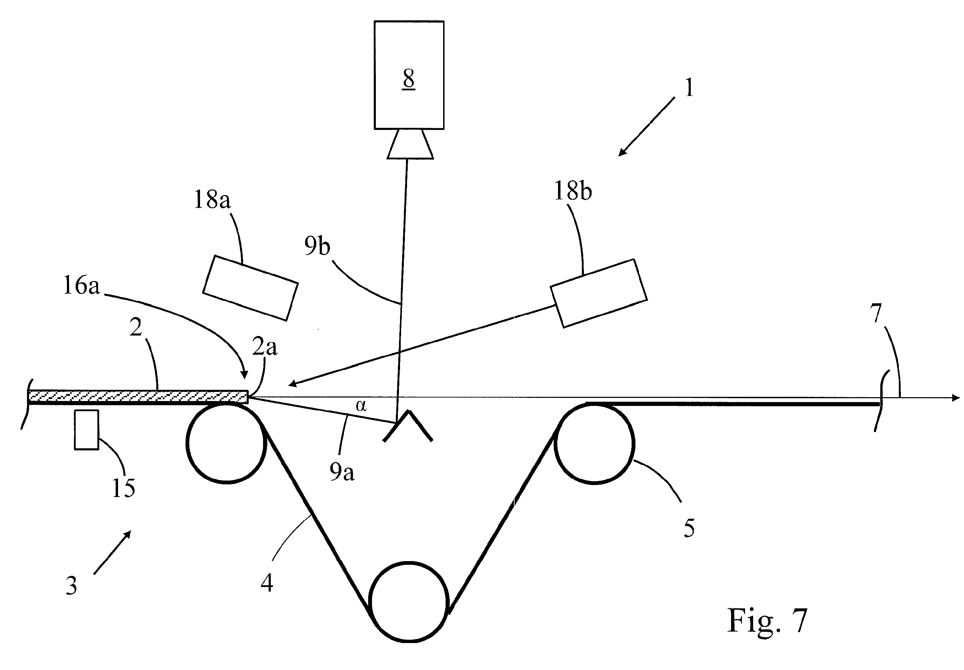

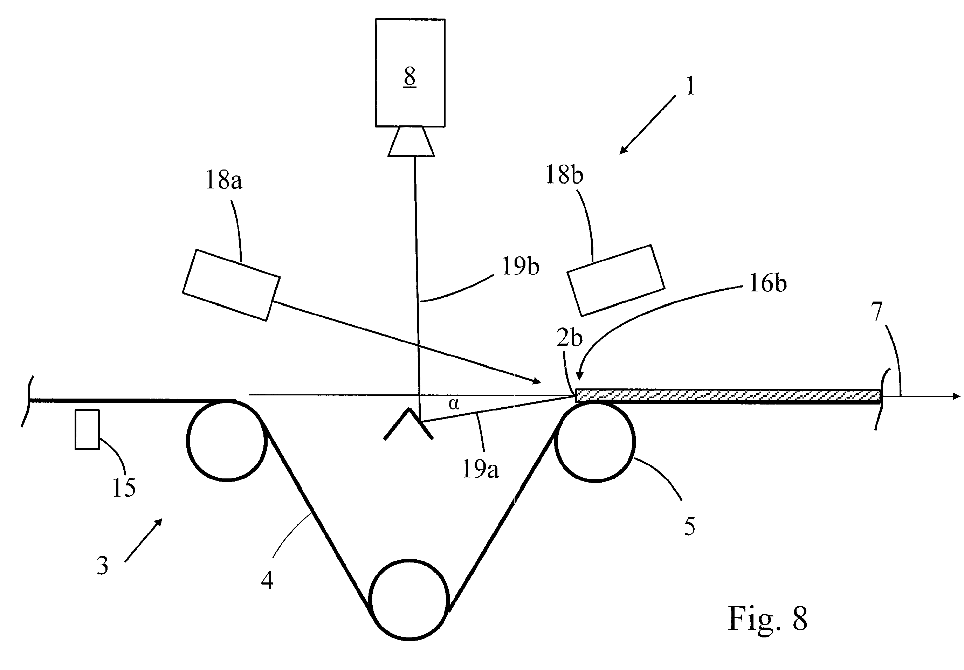

Illumination is not essential to the invention, but may be a preferred embodiment for a robust machine. The illumination (e.g. LEDs) can be placed as indicated in the Figs. 7 and 8.

The mirror arrangement 10 and/or the imaging means 8 may also be placed on the opposite side of the plane of the transport path 6.

If two consecutive conveyer belts are used or the wires of the conveyer are lead far down, the camera may be placed below and the mirror arrangement 10 above the transport plane of the wafers.

The angle between the mirror surfaces is preferably γ=100° so that the optical path of the imaging means 8 is diffracted in two directions. Other optics may allow different angles.

To stress the wafers as less as possible, the cam snap shots shall be done while the wafer is moving with a constant speed (in our case of 220mm/s). That means the cams need an input to do the snap shot at the right time. This is done in the present application for inspecting the leading and the trailing edges with one light barrier, which is installed between the two tracks of the conveyor belt.

In the measurement process, the leading wafer edge passes the light barrier, the signal state of the light barrier changes from low to high and the timer I (timer for the snap shot of the leading edge) and the timer II (timer for snap shot of the trailing edge) begins to count up the time. When the time of the timer I is equal to the adjusted time I, the cam gets the input to trigger the snap shot of the leading wafer edge. When the time of the timer II is equal to the adjusted time II, the cam gets the input to trigger the snap shot of the trailing wafer edge. The time for the timer may be adjustable in a parameter map.

Due to the fact that the snap shot is done while the wafer is moving with a constant speed, the exposure time of the cams has to be at most 100µs to avoid smearing effects and thus enough illumination is needed.

A possible triggering procedure will be described with respect to Fig. 7 and 8. Fig. 7 and Fig. 8 show a preferred operational mode of the inspection system 11. When the object 2 moves in transport direction 7 a sensor 15 detects the object 2 at a sensing (detection) position. Preferably, sensor means 15 is a light barrier. The sensor means 15 is controllably connected (not shown) with the imaging means 8.

From transport velocity the time is known after which the leading edge 2a reaches a first imaging position 16a (Fig. 7). In this imaging position 2a a first image is taken by the imaging means 8 from the observation optical path 9. The imaging means 8 is triggered by the sensor 15. Preferably, an illumination means 18b illuminates the leading edge 2a during imaging.

From transport velocity also the time is known after which the object 2 reaches a second imaging position 16b with its trailing edge 2b (Fig. 8). In this imaging position 2b a second image is taken by the imaging means 8 from the observation optical path 19. The imaging means 8 is triggered by the sensor 15. Preferably, an illumination means 18a illuminates the trailing edge 2b during imaging.

Fig. 9 shows the deflected fields of view of the cameras overlapping the edge of the object 2.

Fig. 10 shows in a schematic illustration the geometrical distances between mirror surfaces, imaging positions and transport plane. As described previously, two mirrors 11, 12 are used to split the visible field of the imaging means 8 in two directions. To meet - in the preferred embodiment - the wafer edge surface with the observation optical path of the imaging means with a divergence of at most 10° to the perpendicular (see figure 1), the top edges of the mirror surfaces 11, 12 (in the present embodiment connected by a common edge) have to be aligned with a maximum distance of a=0,5mm to the conveyor belt 4.

Preferably, the maximum value of the distance d between the edge in the imaging position and the top mirror edges should be 20mm. Together with the requirement of the maximum angle divergence of 10° we get a range of: z = d * tan(10°) = 3,5mm. The projection of the object's edge on the mirror surface may not downwardly extend the position z, in order to not exceed the maximum angle of the observation optical path section of preferably 10 degrees. That means if it is kept in a range of z-a=3mm on each mirror surface 11, 12 for the projection of the wafer edge, the requirement of the maximum angle difference of 10° is met.

The angle between the mirror surfaces has to be about 90° in the embodiment of Fig. 10 and the bisecting line (common edge) of the two mirror surfaces has to be aligned rectangular to the conveyor belt(s) 4.

Preferably, the mirror surface is polished stainless steel.

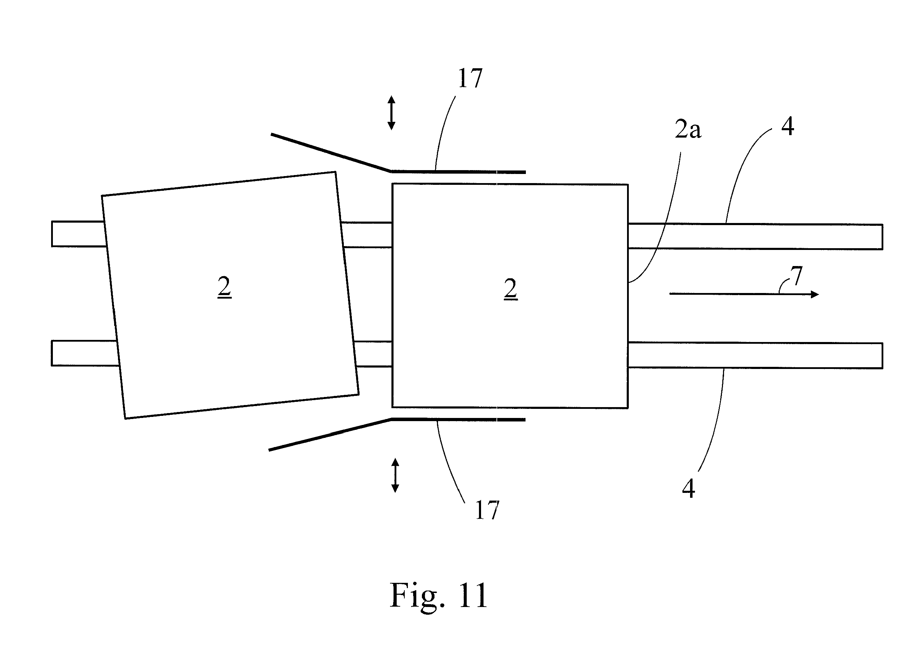

Fig. 11 shows a part of a preferred inspection system. The inspection system 1 includes an alignment tool 17 for aligning the objects 2 (with its lateral edges) parallel to the transport direction 7. The alignment tool 17 is comprised of converging guides being arranged on the lateral sides of the transport path 6.

To take images with desired image sharpness, test results have shown that it is preferred to position the wafers with a tolerance of +/- 2mm from the position with the best image sharpness. That means the front side and back side edges of wafers with the deviation 156mm x 156mm have to be placed with a maximum angle divergence of +/- 1,5° compared to a rectangular alignment to the conveyor belt.

The wafers are aligned during their transport on the conveyor belt by means of the alignment tool 17. It has to be placed upstream of the first imaging position 16a of the inspection system 1. The wafer alignment tool 17 has a v-type entrance portion and a parallel portion (e.g. with a length of 50mm). The v-type entrance portion guides the wafer into the parallel motion. The latter aligns the front side and back side edges rectangular to the conveyor belt.

To adjust the wafer alignment for other wafer sizes, the guides are movably mounted on an axis. So it is possible to move the guides to the right position for different wafer sizes (indicated by the double arrows).

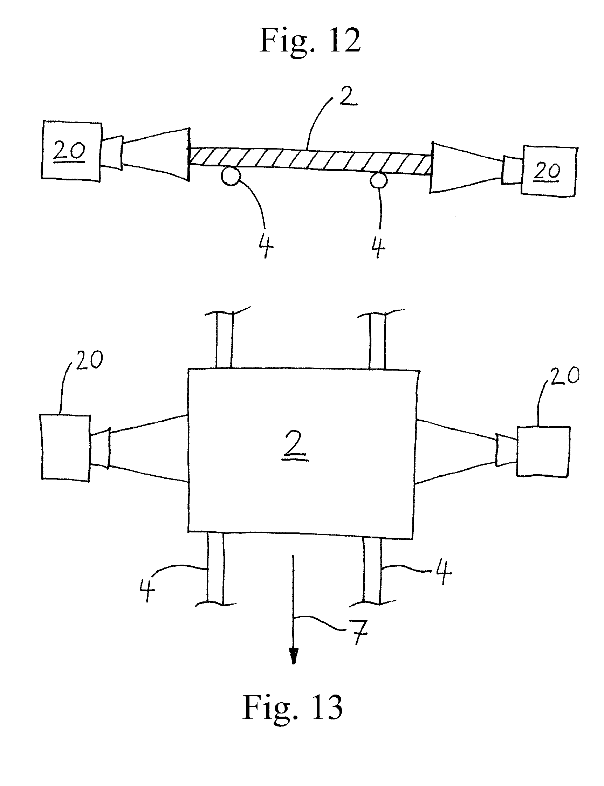

Fig. 12 shows in a front view (from transport direction) a possibility of how to inspect the lateral edges of the object 2 (edges parallel to the transport direction 7). Fig. 13 shows the same arrangement from a top view. Additional imaging means 20 are arranged laterally from the transport path 6.

That means the optical axis of the opposing imaging means 20 are aligned horizontally in the transport plane and rectangular to the conveyor belts 4 which run in the transport plane. To prevent the illumination of one camera blinding the other camera, images are not taken at exactly the same moment and the illumination is turned off accordingly.

Fig. 14 shows different types of damages, v-type breakages 21 and chippings 22. With prior art methods it is not possible to reliably detect especially shallow chippings 22, without rotating the wafer if they are on an object side facing away from the camera.

This is seen from Fig. 15 showing an inspection method according to prior art. Defects that do not extend to the top or bottom surface of the object 2 cannot be detected by prior art methods.

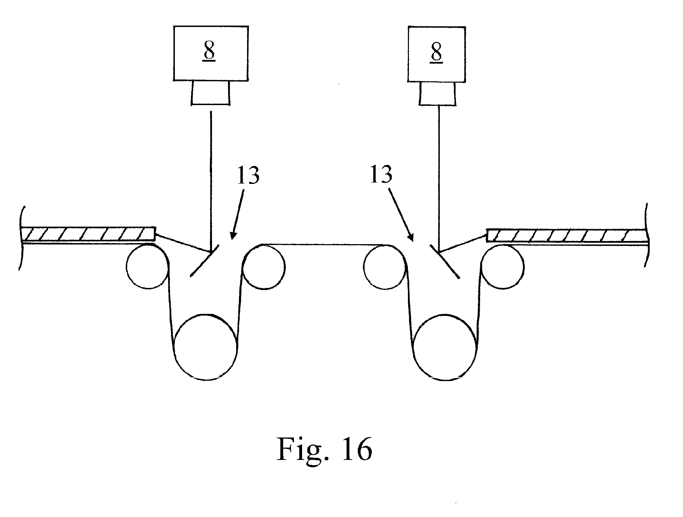

Fig. 16 shows a further embodiment of the inventive inspection system. In this embodiment the transport means has two gaps 13. In each gap 13 there is a mirror arrangement with one mirror surface which is in optical communication with an imaging means. The mirror surface in one gap (left) is adapted to deflect the optical path section for detecting the leading edge to the first imaging means. The mirror surface in the other gap (right) is adapted to deflect the optical path section for detecting the trailing edge to the second imaging means. The cameras above the transport path may be each e.g. a TDI line scan camera.

The invention is not restricted to the embodiments shown. Single or multiple combinations thereof are possible.

### List of reference signs

1 inspection system
2 flat objects
3 transport means
4 conveyor belt
5 roller
6 transport path
7 transport direction
8 imaging means
9 observation optical path
9a, 9b observation optical path section
10 mirror arrangement
11 mirror surface
12 mirror surface
13 gap
14 deflection of the belt 4
15 sensor means
16a, 16b imaging position
17 alignment tool
18a, 18b illumination means
19 observation optical path
19a, 19b observation optical path section
20 camera
21 v-type breakages
22 chippings
23 background shield

## Claims

1. Inspection system (1) for inspecting flat photosensitive semiconductor objects (2), such as wafers, solar cells or intermediate stages thereof, said inspection system (1) comprising:
transport means (3) for transporting the flat objects (2) within a transport path (6) in a transport direction (7);
imaging means (8) for imaging the leading edges (2a) and/or trailing edges (2b) of the flat objects (2) within the transport path (6) from at least one observation optical path (9, 19);
a mirror arrangement (10) having at least one mirror surface (11) deflecting the observation optical path (9);
wherein the mirror arrangement (10) is arranged above or beneath the transport path (6) and extends transversely to the transport direction (7),
and wherein the observation optical path section (9a) that extends from the transport path (6) to the mirror surface (11) encloses an observation angle (α) with the transport direction (7), wherein preferably the observation angle (α) is less than 45 degrees.

2. Inspection system according to claim 1, wherein the observation angle (α) is less than or equal to 15 degrees, preferably less than or equal to 10 degrees.

3. Inspection system according to claim 1 or 2, wherein the mirror arrangement (10) has two mirror surfaces (11, 12) being inclined to each other and defining two observation optical paths (9, 19), one of them being adapted for inspecting the leading edges (2a) of the flat objects (2) and one of them being adapted for inspecting the trailing edges (2b) of the flat objects (2).

4. Inspection system according to claim 3, wherein both mirror surfaces (11, 12) are arranged in the field of view of the same imaging means (8) and both observation optical paths (9, 19) originate from the imaging means (8).

5. Inspection system according to claim 3 or 4, wherein the angle (γ) of inclination between the two mirror surfaces (11, 12) amounts between 80 and 110 degrees, preferably between 90 and 100 degrees.

6. Inspection system according to any of the preceding claims, wherein the transport means (3) has at least one gap (13), in which a mirror arrangement (11, 12) is located beneath the transport path (6).

7. Inspection system according to any of the preceding claims, wherein the inspection system (1) has at least one illumination means (18a, 18b) for illuminating the leading edge (2a) and/or the trailing edge (2b) of the flat object (2) and wherein the angle between the illumination path of the illumination means (18a, 18b) and the observation optical path section (9a, 19a) that extends from the transport path (6) to the mirror surface (11) is smaller than 20 degrees, preferably smaller than 10 degrees.

8. Inspection system according to claim 7, wherein the gap (13) is made by a local deflection (14) of the belt(s) (4).

9. Inspection system according to claim 7, wherein the gap (13) is provided between two separate sections of the transport means (3).

10. Inspection system according to any of the preceding claims, wherein a sensor means (15), preferably a light barrier, is arranged at a detection position of the transport path (6) for detecting the flat object (2), and wherein the sensor means (15) is connected with the imaging means (8).

11. Inspection system according to any of the preceding claims, wherein the observation optical path section (9b) extending between the mirror surface (11) and the imaging means (8) has an angle (β) with the plane of the transport path (6) between 80 to 100 degrees, preferably between 85 and 95 degrees, most preferably approximately 90 degrees.

12. Inspection system according to any of the preceding claims, wherein the inspection system (1) includes an alignment tool (17) for aligning the objects (2) parallel to the transport direction (7), wherein preferably the alignment tool (17) is comprised of converging guides being arranged on the lateral sides of the transport path (6), and wherein preferably the guides are movable with respect to the transport means (3) in a transversal direction to the transport direction (7).

13. Inspection method for inspecting flat photosensitive semiconductor objects (2), such as wafers, solar cells or intermediate stages thereof, said inspection method (1) comprises the steps of:
transporting the flat objects (2) within a transport path (6) in a transport direction (7);
imaging the leading edges (2a) and/or trailing edges (2b) of the flat objects (2) within the transport path (6) from at least one observation optical path (9, 19);
wherein the observation optical path (9, 19) is deflected by a mirror surface (11) of a mirror arrangement (10);
wherein the mirror arrangement (10) is arranged above or beneath the transport path (6) and extends transversely to the transport direction (7),
and wherein the observation optical path section (9a) that extends from the transport path (6) to the mirror surface (11) encloses an observation angle (α) with the transport direction (7), wherein preferably the observation angle (α) is less than 45 degrees.

14. Inspection method according to claim 13, wherein the observation angle (α) is less than or equal to 15 degrees, preferably less than or equal to 10 degrees.

15. Inspection method according to claim 13 or 14, wherein the inspection method is performed with an inspection system (1) according to any of the claims 1 to 12.
